(19)

Europäisches Patentamt
European Patent Office
Office européen des brevets

(11) **EP 3 743 976 B1**

(12) **EUROPEAN PATENT SPECIFICATION**

(45) Date of publication and mention
of the grant of the patent:
**28.06.2023 Bulletin 2023/26**

(21) Application number: **19700848.5**

(22) Date of filing: **23.01.2019**

(51) International Patent Classification (IPC):
**H02J 3/38** *(2006.01)*    **G01R 27/16** *(2006.01)*
**H02J 3/46** *(2006.01)*    **H02J 3/01** *(2006.01)*

(52) Cooperative Patent Classification (CPC):
**G01R 27/16; H02J 3/381; H02J 3/42; H02J 3/46;**
**H02J 3/48; H02J 3/50;** G01R 21/001;
H02J 2300/24; Y02E 10/56

(86) International application number:
**PCT/EP2019/051665**

(87) International publication number:
**WO 2019/145376 (01.08.2019 Gazette 2019/31)**

(54) **GRID CONDUCTANCE AND SUSCEPTANCE ESTIMATION FOR POWER CONTROL IN GRID-TIED INVERTERS**

NETZLEITUNGS- UND BLINDLEITWERTSCHÄTZUNG ZUR LEISTUNGSSTEUERUNG BEI NETZGEBUNDENEN WECHSELRICHTERN

ESTIMATION DE CONDUCTANCE ET DE SUSCEPTANCE DE RÉSEAU POUR LA COMMANDE DE PUISSANCE DANS DES ONDULEURS CONNECTÉS À UN RÉSEAU

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **25.01.2018  LU 100681**

(43) Date of publication of application:
**02.12.2020  Bulletin 2020/49**

(73) Proprietor: **Université du Luxembourg**
**4365 Esch-sur-Alzette (LU)**

(72) Inventors:
• **KOBOU NGANI, Patrick**
  **4365 ESCH-SUR-ALZETTE (LU)**
• **HADJI-MINAGLOU, Jean-Régis**
  **4365 ESCH-SUR-ALZETTE (LU)**

(74) Representative: **Aronova**
**Aronova S.A.**
**BP 327**
**12, avenue du Rock'n'Roll**
**4004 Esch-sur-Alzette (LU)**

(56) References cited:
WO-A1-2016/202859    CN-A- 105 119 301
US-A1- 2010 138 061    US-A1- 2015 023 063

• **Patrick KOBOU NGANI: "ACTIVE HARMONICS COMPENSATION IN SMART GRIDS", DISSERTATION, 24 November 2017 (2017-11-24), pages 1-173, XP055458320, DOI: 10.1109/TSG.2016.2578178 Retrieved from the Internet: URL:http://orbilu.uni.lu/bitstream/10993/3 4280/1/KobouNganiPatrickfinalthesisActiveH armonicsCompensationInSmartGrids.pdf [retrieved on 2018-03-12]**
• **Lei Wang ET AL: "Design of a Thyristor Controlled LC Compensator for Dynamic Reactive Power Compensation in Smart Grid", IEEE Transactions on Smart Grid, 1 January 2017 (2017-01-01), pages 409-417, XP055458320, Piscataway DOI: 10.1109/TSG.2016.2578178 Retrieved from the Internet: URL:http://orbilu.uni.lu/bitstream/10993/3 4280/1/KobouNganiPatrickfinalthesisActiveH armonicsCompensationInSmartGrids.pdf**

**Description**

**Field of the Invention**

The invention generally relates to a method and a computer program product for operating a voltage source inverter (VSI) connected to a power grid as well as to an on-the-fly grid conductance and susceptance estimation method using a VSI. The invention also relates to a VSI configured to carry out the method for operating a VSI connected to a power grid.

**Background of the Invention**

The share of the renewable energy sources in the total electricity production has considerably increased and it will continue to increase over the next decades. Photovoltaic power plants, biogas plants as well as wind farm power plants need to be able to deliver or absorb a certain power according to their capabilities without causing any disturbance or instability (or very limited disturbances or instabilities) in the low-voltage grid to which they are coupled and, *in fine*, to the main power grid.

In general, the impedance of the power grid is considered as essentially inductive, and with a negligible resistive component. Although this hypothesis may be acceptable for high and medium-voltage grids, low-voltage grids not only have a non-negligible resistive component but also exhibit variations from one place to another depending on the local low-voltage grid configuration. Moreover, when the grid impedance components, more precisely the ratio of the grid resistance to the grid impedance and the grid inductance to the grid impedance are not accurately known, any variation of the injected or drawn active power will have an impact on the reactive power, and vice versa.

For grid-tied inverter power systems coupled to low-voltage grids, the decoupled control of the exchanged active and reactive power is therefore a major issue.

A variety of techniques addressing the issue of grid impedance detection already exits but they generally exhibit major drawbacks such as a huge computational power requirement and/or temporary degradation of the power quality of the grid due to the injection of "test" signals, e.g. high frequency signals.

Document WO 2014/060065 relates to means for adapting a power rotation angle of an electrical inverter to match the unknown grid impedance at the point of connection. The real and imaginary components of the grid impedance are deduced from the power inverter control parameters and the measured active and reactive power. The disclosed means for adapting the power rotation angle requires significant computational resources since it involves finding the minimum correlation that includes calculating at least one harmonic coefficient using a discrete Fourier transformation and an optimal control.

Document WO 2012/166933 relates to a method and an apparatus for monitoring an AC line for impedance change. The method comprises superimposing a tone on an AC current coupled to the AC line, wherein the tone is a higher frequency than an AC voltage waveform on the AC line. The proposed method clearly impacts the power quality by injecting a high frequency current. In addition, the complexity of the proposed detection method allows only a delayed response of the system. A strong assumption of this method is that the grid impedance is constant at any point of the grid, which is known to be false for low-voltage grids.

Document WO 2001/081938 relates to a system and a method for automatic detection and matching of power line impedance. A modified power line jack circuitry is used to sense the impedance of the power line and to correct its impedance to match the impedance of the power line. By automatically sensing and adjusting the source impedance, the disclosed power line jack maximizes power transfer to and from the power line, reduces radiated power as well as the power line reflection coefficient. The method for sensing the impedance of the power line comprises generating a signal that is injected into the grid and then the response upon this excitation is analysed to find the probable line impedance.

Document EP 1643256 relates to a technique for determining inductive and resistive components of power line impedance. A measurement circuit switches a burden or drain resistor between power line conductors to cause a droop or sag in a voltage waveform. The voltage waveform is sampled prior to inclusion of the resistor in the circuit, as well as after to identify the droop. The short circuit between the power lines is then removed by opening the circuit and a capacitor in the test circuitry causes a resonant ring due to the inductive component of the power line impedance. Based upon the period or frequency of the resonant ring, and upon the voltage measurements with and without the resistor in the circuit, the inductive and resistive components of power line impedance can be computed. Clearly, the proposed technique can trigger security breakers switches. Moreover, the algorithm needs to sample the voltage over a long time span before the impedance can be estimated.

Document DE 19522496 relates to a method for measuring the network impedance in grid-connected inverters. The method involves injecting a short-term voltage increase in the power network and determining the network impedance based on the reaction of the power network to the short-term voltage increase. This method is clearly not disturbance free for the grid.

Document WO 2014/154298 relates to a method for the computer-aided ascertainment of the impedance of an electrical energy network, wherein the electrical voltage, the active power and the reactive power are measured at a connection point, by which an electrical energy production installation is connected to the energy network, at respective successive instants. The impedance value is estimated at respective present instants by means of a computation code that is independent of the phase of the measured voltage. The estimation is carried out only for relatively large variations in the measured voltage or reactive power. Accurate estimation of the impedance is possible at particular operating points of the energy network even without knowledge of voltage phase. The disclosed method can only be used for highly inductive grid systems because the impedance is estimated only after the system notices large variations of both the grid voltage and the reactive power, while the active power variation is very low. In this case, the estimated impedance is representing an estimated inductance. This is again inadequate for low-voltage grids.

Liserre, F. Blaagjerg, R. Teodorescu: "Grid impedance detection via excitation of LCL-filter resonance", IAS annual Meeting, October 2005, teaches an impedance detection method based on the controlled excitation of LCL-filters at the output of power inverters. This method includes the generation of voltage disturbances and this is not welcome for power quality reasons.

Lucian Asiminoaei, Remus Teodorescu, Frede Blaabjerg, Uffe Borup: "A Digital Controlled PV-Inverter with Grid Impedance Estimation for ENS Detection", IEEE transactions on power electronics, vol. 20, no. 6, November 2005 proposes an online grid impedance estimation method based on the analysis of the voltage response after injecting inter-harmonic currents. Another publication, namely Jonas De Kooning, Jan Van de Vyver, Jeroen D. M. De Kooning, Tine L. Vandoorn, Lieven Vandevelde: "Grid voltage control with wind turbine inverters by using grid impedance estimation", Renewable Power Generation Conference (RPG 2014), September 2014, teaches a similar method as Lucian Asiminoaei et al. Still another publication, namely Surena Neshvad, Symeon Chatzinotas, Jürgen Sachau: "Online Determination of Grid Impedance Spectrum through Pseudo-Random Excitation of a Pulse Width Modulator", International Conference on Renewable Energies and Power Quality (ICREPQ'14), teaches a similar method as the two preceding publications.

Xiaoqiang Guo, Zhigang Lu, Xiaofeng Sun, Herong Gu, Weiyang Wu: "New grid impedance estimation technique for grid-connected power converters", Journal of Eng. Research Vol. 2 - (3) Sept. 2014 pp. 177-193 proposes an online impedance estimation. The estimation is based on the inherent switching frequencies of the power inverter. The method remains, however, very specific since the voltage and current components at the excited frequencies should be known in advance. The proposed system does not generate additional "disturbing signals" in the sense of the previous documents but uses a non-filtered modulated voltage (PWM) which are disturbances for the grid. Moreover such a configuration for PWM is no longer the applied standard because, nowadays, the PWM output is filtered by LC or LCL passive filters to obtain a pure sinusoidal voltage. In addition, the system is configured to be executed on super-fast microcontroller because of the very high voltage and current harmonic order to be extracted (198th order for a 10 kHz inverter). The best active harmonics filters on the market operate up to the 52nd order and have inverters with higher switching frequencies (between 15 and 20 kHz). Furthermore, at such a high harmonic frequency, the voltage and the current are extremely small and therefore requires very accurate and very expensive sensors for detecting them.

Abdelhady Ghanem, Mohamed Rashed, Mark Sumner, M. A. El-sayes and I. I. I. Mansy: "Grid Impedance Estimation for Islanding Detection and Adaptive Control of Converters", 8th IET International Conference on Power Electronics, Machines and Drives (PEMD 2016 - 19-21 April 2016, Glasgow, UK) teaches a non-invasive impedance detection method based on the discretized model using only two consecutive samples. The estimated ratio of the resistance to the inductance is highly sensitive to inaccurate measurements. The current measurement is very difficult due to the high switching frequencies of the power inverter. Consequently, the proposed non-invasive impedance detection method suffers from non-negligible inaccuracies.

Kulka, Arkadiusz, Undeland, Tore: "Grid Inductance Estimation by Reactive Power Perturbation for Sensorless Scheme Based on Virtual Flux", Proceedings of the Nordic Workshop on Power and Industrial Electronics (NORPIE/2008) teaches another invasive detection method where two current controllers are performed on the current direct and quadrature axis. A reactive current (quadrature component) is injected and the response of the active current (direct component) controller is analysed. If the active current changes significantly, the decoupling impedance components are not correct. That way the method seeks for the correct values until a variation of the reactive current set point has no impact on the active current anymore. WO 2016/202859 relates to a power inverter for converting source currents or voltages into alternating currents or voltages to be injected into a supply grid which comprises a harmonics compensator configured to detect one or more harmonics of the fundamental frequency of the electrical supply grid and to control the alternating currents or voltages to be injected in such a way as to selectively modify the voltage of at least one of the one or more detected harmonics in accordance with one or more respective targets. A communication interface allows the power inverter to join a network of power inverters. The harmonics compensator is configured to share some or all of its operating parameters over the network and to adjust the one or more targets depending on instructions and/or operating parameters communicated to it via the network. WO 2016/202859 also relates to a control unit for centrally controlling such power inverters.

**General Description**

A power grid, also named electrical grid, is an interconnected network for delivering electricity from producers to consumers. Power grids may vary in size from covering a single building through national grids, which cover whole countries, to transnational grids, which can cross continents. A power grid comprises power-generating stations that produce electrical power (e.g. nuclear power plants, coal power plants or more ecologically friendly power plants such as photovoltaic power plants, biogas plants, wind farm power plants, etc.), high voltage transmission lines that carry electric power from distant sources to demand centres, and distribution lines

that connect individual customers. For example, at the level of the individual customers in the Regional Group Continental, an electrical signal, having a frequency of 50 Hz and a grid voltage magnitude of 220 V RMS (root mean square), is delivered to the customers.

An increasing part of individual customers now possess their own power-generating station (comprising e.g. photovoltaic cells on the rooftop of their home) that produces electrical power. Due to the increasing number of individual producers injecting their locally generated electrical power as well as test signals into the grid, the question of disturbances or instabilities of the power grid gains rapidly in importance.

Local power-generating stations generally comprise a voltage source inverter (VSI) in order to transform the locally generated DC electrical signal (e.g. by photovoltaic cells or batteries) into a grid-acceptable AC electrical signal. A grid-acceptable AC electrical signal is an electrical signal that effectively permits a net exchange of electrical power between the VSI and the power grid.

A first aspect of the invention relates to a method for operating a VSI connected to a power grid having a grid voltage. The method comprises:

- controlling a magnitude of a VSI voltage and a phase between the VSI voltage and the grid voltage;
- determining active and reactive powers exchanged between the VSI and the grid;
- estimating one or more values indicative of the ratio of a grid conductance and of a grid susceptance based on the active and reactive powers;
- determining an active power deviation between the determined active power and an active power setpoint as well as a reactive power deviation between the determined reactive power and a reactive power setpoint;
- mapping the active and reactive power deviations to a phase deviation and to a magnitude deviation, the mapping being dependent on the estimated one or more values indicative of the ratio of the grid conductance and the grid susceptance; and
- correcting the magnitude of the VSI voltage and the phase between the VSI voltage and the grid voltage, based on the phase and magnitude deviations.

It will be appreciated that the method according to the first aspect of the invention does not need test signals injected into the grid for determining one or more values indicative of the ratio of a grid conductance and of a grid susceptance. It will also be appreciated that the method according to the first aspect of the invention implements a negative feedback loop, since the phase and magnitude deviations are used for correcting the magnitude of the VSI voltage and the phase between the VSI voltage and the grid voltage. More precisely, the method implements a negative feedback power control loop for the active and reactive powers.

Power in an electric circuit is the rate of electrical energy flowing (per time unit) through a given point of the electric circuit. In AC circuits, the portion of power that, averaged over a cycle of the AC waveform, results in net transfer of energy is known as "active power". The portion of power due to the stored energy (such as the energy stored in inductors and capacitors), which returns to the source in each cycle, is known as "reactive power".

The grid may be a one-phase grid and the VSI may be a one-phase VSI. Alternatively, the grid may be a three-phase grid and the VSI may be a three-phase VSI. It will be appreciated that that the method according to the first aspect of the invention is suitable for any number of phases or any electrical power waveform. In particular, any electrical power waveform characteristic (e.g. the magnitude and the frequency of the grid voltage as well as the Total Harmonics Distortion (THD)) could be specified for the grid.

The active and reactive powers exchanged between the VSI and the grid may be determined based on the VSI voltage and a corresponding VSI current. Preferably, the active P and reactive Q powers are computed according to

$$P = Re(S), \tag{1}$$

$$Q = Im(S), \qquad\qquad (2)$$

with

$$S = \left(V_{VSI} - V_{grid}\right)I^{*}, \qquad\qquad (3)$$

where $V_{VSI}$ is the complex grid-acceptable VSI voltage, $V_{grid}$ is the complex grid voltage, $I$ is the complex current flowing through the VSI, S is the complex power delivered by the VSI to the grid and $Re$, $Im$, * are the real and imaginary part and the complex conjugate, respectively. The active P and reactive Q powers could be determined by an electricity meter such as, e.g., an electronic electricity meter or a combination of voltage and current meters like voltmeters and Hall sensors. The determined active and reactive powers may be filtered (e.g. numerically and/or by a moving average). This filtering step may be beneficial to remove, e.g., any remaining non-filtered high frequency components contained in the active and reactive powers.

Estimating the one or more values indicative of the ratio of the grid conductance and of the grid susceptance based on the active and reactive powers may comprise estimating the grid conductance, the grid susceptance, the grid resistance or the grid reactance, or any combination thereof (e.g. ratio, multiplication), or any combination (e.g. ratio, multiplication) between one of the preceding grid characteristics and the grid impedance or grid admittance or any function thereof, e.g. the ratio between the grid resistance and a norm of the grid impedance, the ratio between the grid reactance and a norm of the grid impedance.

The estimation of the one or more values indicative of the ratio of the grid conductance and of the grid susceptance could also be based on the phase and magnitude deviations.

Preferably, estimating one or more values indicative of the ratio of the grid conductance and of the grid susceptance based on the active P and reactive Q powers comprises computing the ratio R/|Z| between the grid resistance R and the norm of the grid impedance |Z| as well as the ratio X/|Z| between the grid reactance and the norm of the grid impedance |Z| according to the following equations:

$$\begin{pmatrix} \frac{R}{|Z|} \\ \frac{X}{|Z|} \end{pmatrix} = \frac{1}{\sqrt{G^2 + B^2}} \begin{pmatrix} |G| \\ |B| \end{pmatrix}, \qquad\qquad (4)$$

with

$$\begin{pmatrix} G \\ B \end{pmatrix} = \frac{2}{\hat{V}_{VSI}} \frac{1}{(\Delta U)^2 + (\lambda \cdot \hat{V}_{VSI})^2} \begin{pmatrix} -\Delta U & \lambda \cdot \hat{V}_{VSI} \\ \lambda \cdot \hat{V}_{VSI} & \Delta U \end{pmatrix} \begin{pmatrix} P \\ Q \end{pmatrix}, \qquad\qquad (5)$$

where G is the grid conductance, B is the grid susceptance, $\Delta U$ is the difference between the magnitude of the grid voltage $\hat{V}_{grid}$ and the magnitude of the VSI voltage $\hat{V}_{VSI}$, and $\lambda$ is the phase angle difference between the grid voltage $V_{grid}$ and the VSI voltage $V_{VSI}$. $\Delta U$ may be approximated by the magnitude variation $\Delta U'$ of the VSI voltage and $\lambda$ may be approximated by the phase difference between the voltage $V_{PCC}$ at the point of coupling between the grid and the VSI, hereinafter referred to as the point of common coupling (PCC), and the voltage of the VSI, $V_{VSI}$.

Determining the active and reactive power deviations could comprise determining the absolute error between the determined active and reactive powers and the respective setpoints, i.e. the difference between the determined active and reactive powers and the respective setpoints. Alternatively or additionally, determining the active and reactive power deviations could comprise determining the relative error between the determined active and reactive powers and the respective setpoints, i.e. the absolute error divided by the respective setpoints.

The active and reactive power setpoints may be constant or vary in time. They could be varied in such a way as to take into account environmental factors such as weather conditions that could affect the grid stability, e.g. sunshine duration (e.g. for photovoltaic installations) and/or wind speed (e.g. for wind turbines). The setpoints could also be varied based on the grid requirements and the actual grid state (i.e. the magnitude of the grid voltage and the frequency of the grid voltage and their variations). In this case the setpoints could be varied so as to e.g. reduce variations of the magnitude of the grid voltage and the frequency of the grid voltage. The setpoints may be automatically determined, e.g. by an algorithm. The setpoints may also be imposed by a grid operator.

Mapping the active and reactive power deviations to a phase deviation and to a magnitude deviation could comprise expressing the active and reactive power deviations with respect to the grid complex admittance or impedance frame of reference i.e., with respect to the orthogonal admittance components that are the conductance and the susceptance or the orthogonal impedance components that are the resistance and the inductance, respectively, thereby obtaining phase and magnitude deviations. Preferably, the active $e_P$ and reactive $e_Q$ power deviations are mapped to phase $e_\lambda$ and magnitude $e_{\Delta U}$ deviations according to the following equation:

$$\begin{pmatrix} e_{\Delta U} \\ e_\lambda \cdot \widehat{V}_{VSI} \end{pmatrix} = \frac{2}{\widehat{V}_{VSI}} \begin{pmatrix} -\dfrac{R}{|Z|} & -\dfrac{X}{|Z|} \\ -\dfrac{X}{|Z|} & \dfrac{R}{|Z|} \end{pmatrix} \begin{pmatrix} e_P \\ e_Q \end{pmatrix}. \tag{6}$$

In Eq. 6, the voltage magnitude $e_{\Delta U}$ deviation may be computed in volt per ohm (V/$\Omega$), the scaled phase $e_\lambda \cdot \widehat{V}_{VSI}$ deviation in volt per ohm (V/$\Omega$), $\widehat{V}_{VSI}$ in volt (V), the resistance R and the impedance Z in ohm ($\Omega$) and the active $e_P$ and reactive $e_Q$ power deviations in watt (W).

As shown in Eq. 6, the phase $e_\lambda$ and magnitude $e_{\Delta U}$ deviations may be computed with respect to the ratio of the resistance R and the impedance and the ratio of the inductance X to the impedance Z. It will be appreciated that working with the ratio of the resistance and the inductance to the impedance (or any other value indicative of the ratio of the grid resistance and the grid inductance) allows an easy configuration of the correction step, so that the correction step is not dependent on the absolute values of the grid resistance and inductance.

Correcting the magnitude of the VSI voltage and the phase between the VSI voltage and the grid voltage preferably comprises regulating the magnitude of the VSI voltage and the phase between the VSI voltage and the grid voltage so as to reduce the active and reactive power deviations. In other words, the magnitude of the VSI voltage and the phase between the VSI voltage and the grid voltage are regulated by the negative feedback loop so as to reduce the discrepancies between the active and reactive powers and their respective setpoints.

The correction could comprise injecting the phase and magnitude deviations into a proportional controller, integral controller, a derivative controller or a combination thereof. The output of the controller is used for regulating the magnitude of the VSI voltage and the phase between the VSI voltage and the grid voltage so as to reduce the active and reactive power deviations. Preferably, the controller is a proportional-integral controller or a proportional-integral-derivative controller. As explained above, the use of a value indicative of the ratio of the grid resistance and the grid inductance (e.g. the ratio of the inductance X to the impedance Z) allows an easy configuration of the controller, so that the dynamic of the controller is not impacted by the absolute values of the grid resistance and inductance.

In a preferred embodiment, the method comprises comparing the active and reactive power deviations to respective active and reactive power deviation thresholds. The mapping and correcting steps could in this case be carried out as long as at least one of the active and reactive power deviations is greater than the respective threshold. The mapping and correcting steps could be suspended when both active and reactive power deviations are smaller than the respective thresholds.

The active and reactive power deviation thresholds could be constant or variable in time. The specific values for the active and reactive power deviation thresholds could be set manually by a user or adjusted automatically by a controller, for example integrated in the VSI controller.

In a preferred embodiment, the method comprises an initial synchronisation of the VSI with the grid.

A second aspect of the invention relates to an on-the-fly power grid conductance and susceptance estimation method using a VSI connected to a power grid. The method according to the second aspect of the invention carries out the steps of the method according to the first aspect of the invention.

A third aspect of the invention relates to a computer program product comprising a program for operating a VSI connected to a power grid, the program comprising instructions, which, when executed by a computer controlling the VSI, causes the computer to carry out the steps of the method according to the first aspect of the invention.

The electronic circuits of the computer may comprise or consist essentially of a general-purpose microprocessor, an application-specific integrated circuit (ASIC), a system on a chip (SoC), a programmable logic circuit, a special purpose microprocessor or a programmed generic microprocessor. Among the programmable logic circuits, the implementation of the processor could a field-programmable gate array (FPGA), a programmable logic device (PLD), an erasable programmable logic device (EPLD), a complex programmable logic device (CPLD), programmable logic array (PLA), or other.

A fourth aspect of the invention relates to a VSI configured to carry out the steps of the method according to the first aspect of the invention. Such a VSI could, e.g., comprise a microcontroller programmed to carry out the method as described hereinabove.

The VSI could comprise a switch for selectively carrying out the method for operating the VSI according to the first aspect of the invention. The switch could comprise a hardware switch, such as, e.g. a biased switch, a rotary switch, a toggle switch, etc., or a software switch, or a software-operated hardware switch.

EP 3 743 976 B1

A fifth aspect of the present invention relates to a VSI controller configured to carry out the steps of the method according to the first aspect of the invention. The VSI controller could comprise a switch for selectively carrying out the method.

The VSI controller could comprise a software controller and/or a hardware controller. Any electronic circuits of the VSI controller could comprise or consist essentially of a general-purpose microprocessor, an application-specific integrated circuit (ASIC), a system on a chip (SoC), a programmable logic circuit, a special purpose microprocessor or a programmed generic microprocessor. Among the programmable logic circuits, the implementation of the processor could a field-programmable gate array (FPGA), a programmable logic device (PLD), an erasable programmable logic device (EPLD), a complex programmable logic device (CPLD), programmable logic array (PLA), or other. The VSI controller could be configured to carry out the steps of the method through a computer program installed on the VSI controller.

**Brief Description of the Drawings**

The accompanying drawings illustrate several aspects of the present invention and, together with the detailed description, serve to explain the principles thereof. In the drawings:

Fig. 1:    is a schematic layout of a grid-tied VSI circuit;
Fig. 2:    is a flowchart of a method for operating a VSI connected to a power grid;
Fig. 3:    is a schematic layout of an active and reactive power control loop according to an embodiment of the invention;
Fig. 4:    shows experimental results of an active and reactive power control loop of a grid-tied VSI, wherein the magnitude and frequency of the grid voltage are not controlled;
Fig. 5:    shows experimental results of an active and reactive power control loop of a grid-tied VSI, wherein the magnitude of the grid voltage is controlled and the frequency of the grid voltage is not controlled; and
Fig. 6:    shows experimental results of an active and reactive power control loop of a grid-tied VSI, wherein the impedance of the grid is variable.

**Detailed Description of preferred embodiments**

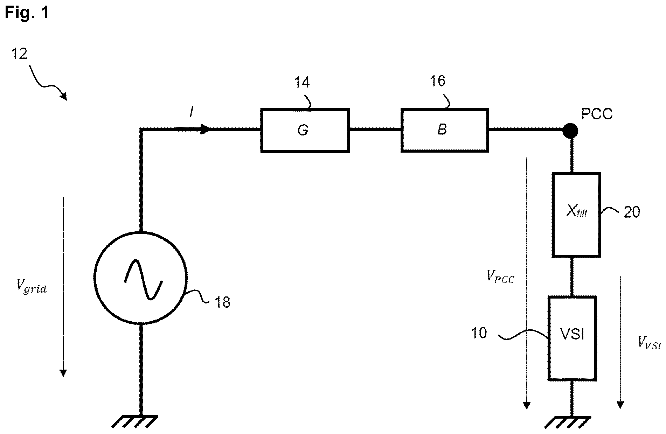

Fig. 1 schematically illustrates a VSI 10 connected to a power grid 12 at a point of common coupling (PCC). The power grid 12 is modelled as having a conductance component G 14, a susceptance component B 16 and an AC source 18 providing a voltage $V_{grid}$ and an associated current I.

The VSI 10 comprises a pulse width modulation (PWM) module providing a high frequency pulsed voltage based on PWM methods such as e.g. sine-triangles or a space vector modulations. The high frequency pulsed voltage is filtered by a low-pass inductive-capacitive filter 20 (e.g. an LC-filter) thereby generating a 50 Hz sinusoidal signal having a very low total harmonic distortion (THD). The two voltage sources are connected together at the PCC leading to the measured voltage at the PCC, $V_{PCC}$.

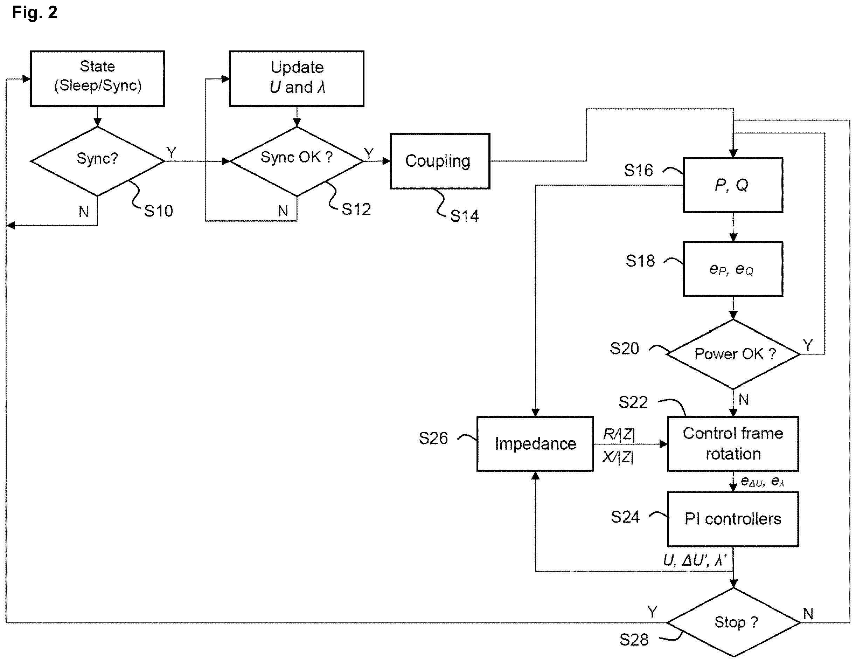

Fig. 2 shows a flowchart illustrating a method for operating a VSI connected to a power grid having a grid voltage according to a preferred embodiment of the invention.

Step S10 comprises checking if synchronization of the VSI with the grid is requested. This request may, for example, be effected by operating an on/off switch of the VSI. If there is no request for synchronisation, the VSI goes to (or remains in) sleep mode, i.e. the VSI is not synchronized with the grid and does not exchange any power with it. In the alternative, the VSI tries to carry out an initial synchronisation with the grid, i.e. the VSI matches the phase, the frequency and the magnitude of the grid voltage.

Step S12 comprises checking if the initial synchronization with the grid is properly accomplished. If this is not the case, the VSI updates the synchronisation parameters for a proper initial synchronization (i.e. a match of the phase, the frequency and the magnitude of the grid voltage). When the synchronisation is okay, the VSI is coupled to the grid at the PCC in step S14.

The magnitude difference $\Delta U$ is defined as the difference between the magnitude $\hat{V}_{grid}$ of the grid voltage $V_{grid}$ and the magnitude $\hat{V}_{VSI}$ of the VSI voltage $V_{VSI}$. The grid remains stable for a certain amount of time. At any later time, the grid voltage, frequency as well as magnitude may differ from the values known at the coupling time (step S14). The magnitude difference $\Delta U$ is well approximated by the magnitude variation $\Delta U'$ applied to the VSI voltage after coupling. At the coupling instant, the magnitude variation $\Delta U'$ is set to zero. This approximation does not affect the stability of the power control since the voltage magnitude variation is relatively low (e.g. approx. 10% of the rated value). Furthermore, any variation will have an immediate impact on the exchanged powers (active and reactive) that will trigger a correction of the VSI output voltage magnitude or phase angle.

The phase angle difference between the grid voltage $V_{grid}$ and the VSI voltage $V_{VSI}$ is $\lambda$. The grid frequency variation significantly affects the exchanged power. Moreover, the effects of variations of the grid frequency are increasing

7

with the time. A good indicator of any grid frequency change is the phase difference between the voltage $V_{PCC}$ at the PCC and that of the VSI $V_{VSI}$, called $\lambda'$, since the grid impedance is considerably lower than the LC filter impedance (20, Fig. 1). The phase-shift $\lambda'$ can be computed as the phase difference between the computed voltage direct (in-phase) component (i.e. component d in the dq orthogonal and rotating reference frame of the VSI) and the voltage at the PCC. At the coupling instant, the phase-shift $\lambda'$ is determined in the dq orthogonal and rotating reference frame by dividing the computed PCC voltage direct component by the PCC voltage magnitude.

In step S16, the exchanged active and reactive powers between the VSI and the grid are determined. The determination comprises measuring the current and the voltage delivered by the VSI and deriving P and Q from the complex power S thus obtained. The determination also comprises filtering P and Q, e.g., by a moving average, for mitigating the effects of any residual non-filtered high frequency components contained in the voltage generated by the VSI or the oscillations of the supply DC voltage (caused by the PWM).

It should be noted that the active P and reactive Q powers depend on the grid admittance, more precisely on the grid conductance G and the grid susceptance B (the orthogonal admittance components) of the circuit between the grid voltage source and the VSI according to the following equation:

$$\begin{pmatrix} P \\ Q \end{pmatrix} = \frac{1}{2} \hat{V}_{VSI} \begin{pmatrix} -G & B \\ B & G \end{pmatrix} \begin{pmatrix} \Delta U \\ \lambda \cdot \hat{V}_{VSI} \end{pmatrix},$$

where $\Delta U$ is the difference between the magnitude of the grid voltage $\hat{V}_{grid}$ and the magnitude of the VSI voltage $\hat{V}_{VSI}$, and $\lambda$ is the phase angle difference between the grid voltage $V_{grid}$ and the VSI voltage $V_{VSI}$. From the above equation, it is clear that, for given $\Delta U$ and $\lambda$, the active and reactive powers will vary if the grid conductance G and/or the grid susceptance B vary.

Step S18 comprises computing respective deviations of the exchanged active $e_P$ and reactive $e_Q$ powers with respect to active and reactive power setpoints (set manually by the VSI user or automatically, e.g. via a grid control centre). This step comprises computing the absolute active and reactive power deviations by subtracting the current active P and reactive power Q from their respective setpoints $P_{sp}$ and $Q_{sp}$ for determining deviations to the setpoints, i.e. $e_P = P - P_{sp}$ and $e_Q = Q - Q_{sp}$. It should be noted that the active $e_P$ and reactive $e_Q$ power deviations could be defined differently, e.g., as $e_P = P_{sp} - P$ and $e_Q = Q_{sp} - Q$ or as relative power deviations, e.g., $e_p = |P - P_{sp}|/|P_{sp}|$ and $e_Q = |Q - Q_{sp}|/|Q_{sp}|$. The power deviations could also be indicated by the absolute power in combination with the relative error, which may be found particularly suitable if the power setpoints vary between large and small (near zero) values.

The active and reactive power deviations are compared to respective active and reactive power deviation thresholds in step S20. If the active and reactive powers deviations are within predetermined thresholds (i.e. each of the active and reactive powers not exceeding their respective thresholds), steps S16-S20 are repeated. If at least one of the active and reactive power deviations is greater than the respective thresholds, the active and reactive power deviations are mapped, in step S22, to a phase deviation $e_\lambda$ and to a magnitude deviation $e_{\Delta U}$ through Eq. 6. This amounts to "rotating" and rescaling the power reference frame to the admittance frame of the VSI. The control of the active and reactive power is thus achieved in the estimated admittance frame, resulting in essentially decoupled error values.

The phase $e_\lambda$ and magnitude $e_{\Delta U}$ deviations are injected into respective proportional-integral controllers (PI controllers) in step S24. The PI controllers determine control variables for the VSI, in particular a new VSI voltage magnitude and a new phase angle that the VSI applies to the PWM signal. The PI controllers thereby effectively correct the VSI output voltage magnitude and the phase between the VSI voltage and the grid voltage in such a way as to reduce the active and reactive power deviations, thereby bringing the active and reactive power values closer to their respective setpoints.

In step S26, the resistive $R/|Z|$ (related to the conductance of the grid) and reactive $X/|Z| = \omega L/|Z|$ (related to the susceptance of the grid) components of the grid are estimated according to

$$\begin{pmatrix} R/|Z| \\ X/|Z| \end{pmatrix} = \begin{pmatrix} G \cdot |Z| \\ B \cdot |Z| \end{pmatrix}$$

with

$$\begin{pmatrix} G \\ B \end{pmatrix} = \frac{2}{\hat{V}_{VSI}} \frac{1}{(\Delta U')^2 + (\lambda' \cdot \hat{V}_{VSI})^2} \begin{pmatrix} -\Delta U' & \lambda' \cdot \hat{V}_{VSI} \\ \lambda' \cdot \hat{V}_{VSI} & \Delta U' \end{pmatrix} \begin{pmatrix} P \\ Q \end{pmatrix} \quad \text{and} \quad |Z| = \frac{1}{\sqrt{G^2 + B^2}}.$$

The values of the resistive and reactive components of the grid impedance may be updated whenever one or more new values for $\Delta U'$, $\lambda'$, P or Q are available. In particular, the value of the resistive and reactive components of the grid are updated when new values for the exchanged active P and reactive Q powers are available (step S16). The values of the resistive and reactive components of the grid are also updated when new values for $\Delta U'$, $\lambda'$ are available from the PI controllers (step S24). Since the grid conductance and susceptance do not change abruptly, the computed conductance and susceptance are filtered (e.g. numerically filtered) in order to eliminate transient power oscillations that could appear, when $\lambda'$ and/or $\Delta U'$, change.

Step S28 comprises checking if VSI shall continue to operate. If it is the case, steps S16-26 are repeated. If it is not the case, the VSI goes to sleep mode.

It will be appreciated that the method can be implemented for a three-phase power grid as well as for a single-phase one.

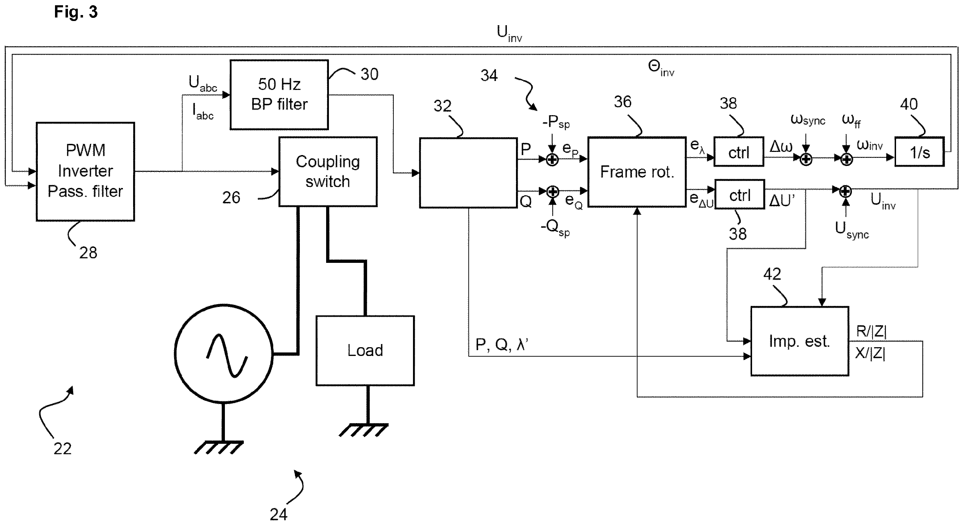

Fig. 3 illustrates an active and reactive power control loop for a three-phase power grid, according to an embodiment of the invention.

The system 22 is coupled to a power grid 24 through a coupling switch 26. The system comprises an electric source 28 comprising a three-phased VSI generating a pulsed-width-modulated voltage and a low-pass passive LC filter for filtering the modulated voltage and generating a sinusoidal voltage (the filter may, e.g. be configured so that it filters the harmonics of the signal and so that the distortion caused by the harmonics that are above the 19th harmonic, which are above 950 Hz, are undetectable - i.e. they are lost in the noise). The low-pass passive LC filter may be a hardware filter. The electric source 28 is initially synchronized with the grid, in the same way as the embodiment illustrated in Fig. 2.

The three-phased voltages $U_{abc}$ and the three-phased currents $I_{abc}$ delivered by the electric source 28 are measured and filtered by a bandpass filter 30 centered on 50 Hz. The bandpass filter 30 extracts the fundamental voltage signal from a voltage signal provided by the grid that could be distorted, containing, for instance, the 5th, the 7th, ..., up to the 19th harmonics. The bandpass filter 30 may be a software filter. The filtered voltage and current measures are then input to a power determination module 32 that calculates the exchanged active and reactive powers as well as the phase difference $\lambda'$ between the voltage $V_{PCC}$ at the PCC and the voltage $V_{VSI}$ of the VSI. The phase-shift $\lambda'$ is determined in the same way as in the embodiment illustrated in Fig. 2. The power determination module 32 may also comprise computing means for determining the phase-shift $\lambda'$ as well as the exchanged active and reactive powers.

The deviations $e_P$, $e_Q$ of the exchanged active and reactive powers with respect to the respective active and reactive power setpoints are then computed (see reference sign 34). The computed deviations $e_P$, $e_Q$ are then injected in the frame rotation module 36. The frame rotation module 36 maps the active $e_P$ and reactive $e_Q$ power deviations to phase $e_\lambda$ and magnitude $e_{\Delta U}$ deviations according to Eq. 6.

The magnitude $e_{\Delta U}$ deviation is then injected in a PI controller 38 that determines the magnitude variation $\Delta U'$ correction for correcting the operation of the PWM of the electric source 28. The magnitude variation $\Delta U'$ correction is added to the synchronization magnitude $U_{sync}$ determined during the initial synchronization of the VSI to yield the voltage $U_{inv}$, which is applied to the electric source 28 as the control parameter for the voltage magnitude.

The phase $e_\lambda$ deviation is injected in a PI controller 38 that determines an instantaneous frequency-shift $\Delta\omega$, which leads to a finite phase-shift over the time. The frequency $\Delta\omega$ shift is then added to the frequency $\omega_{sync}$ of the initial synchronization of the VSI. The resulting frequency is added to the fixed frequency $\omega_{ff}$ of the VSI (i.e. the rated 50Hz or 60Hz) and transformed into instantaneous phase angle $\theta_{inv}$, using the time integrator 40. The instantaneous phase angle $\theta_{inv}$ is applied to the electric source 28 as the control parameter for the voltage phase angle.

The impedance estimator 42 comprises computing means for estimating the resistive $R/|Z|$ and reactive $X/|Z| = \omega L/|Z|$ components of the grid based on the active P and reactive Q power and the phase difference $\lambda'$ determined by the power determination module 32 as well as the magnitude variation $\Delta U'$ and the inverter voltage magnitude $U_{inv}$.

It should be noted that even if the power determination module 32, the frame rotation module 36, the PI controllers 38 and the impedance estimator 42 are depicted in Fig. 3 as separate entities, their functions may be carried out by a single hardware and/or software. For example, the functions of the power module 32, the frame rotation module 36, the PI controllers 38 and the impedance estimator 42 may be implemented by a program installed on a computer operatively connected to the VSI.

Active and reactive power control - Example 1

The system of example 1 comprises a controlled DC voltage source that feeds a VSI. The output voltage of the VSI is filtered using a passive LC filter. A synchronous machine, mechanically connected to an induction motor, is used as a generator and feeds a resistive load simulating a low power micro-grid. The output voltage magnitude and frequency of the synchronous machine are uncontrolled. The filtered output voltage of the VSI is synchronized and coupled to that of the synchronous machine. The active and reactive power exchanged between the VSI and the micro-grid are independently controlled by a VSI controller acting on the VSI output voltage magnitude and phase. The VSI controller carries out the method of the embodiment illustrated in Fig. 1. The VSI controller is a NI cRio-9082 from National Instrument (NI) programmed in LABVIEW™.

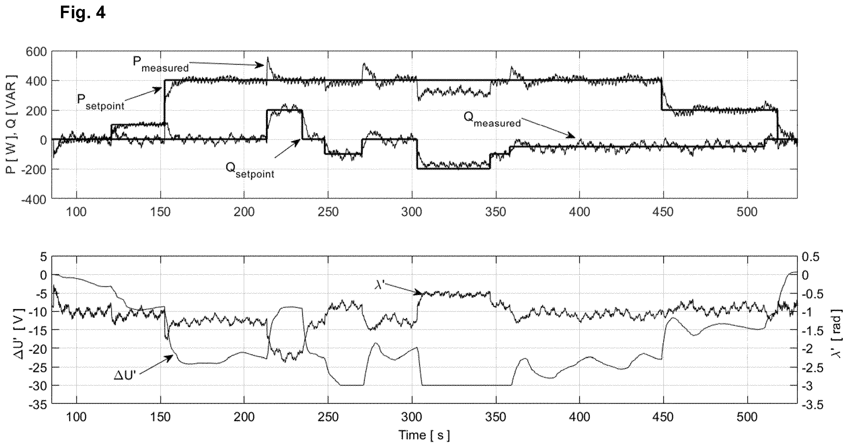

The results are shown in Fig. 4. The active power control is decoupled from the reactive power control: the active and reactive powers P and Q can be regulated independently from each other by adjusting the VSI voltage magnitude and phase, based on the estimated grid resistance and reactance. Transitory regime can be seen when the control setpoints are changed (e.g. at t $\approx$ 150 s, 215 s, 270 s, etc.).

Active and reactive power control - Example 2

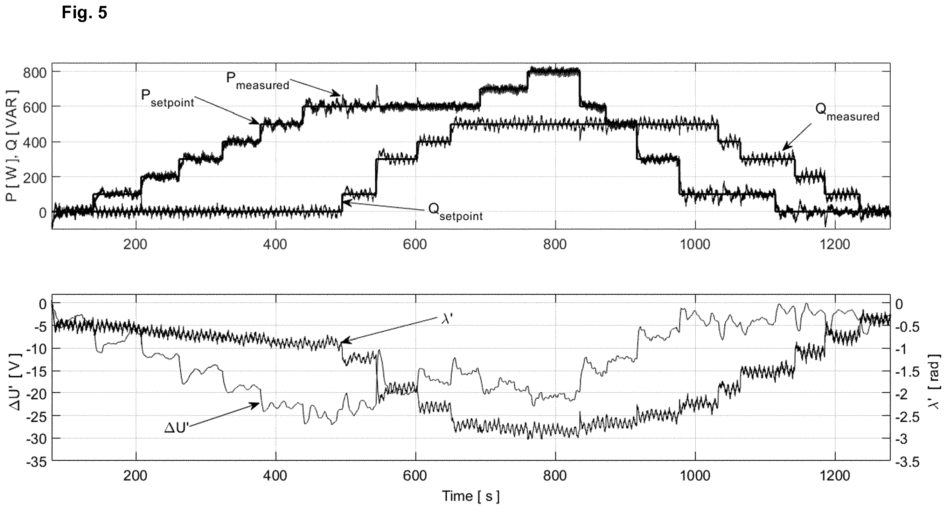

In this example, the system is identical to the one of example 1 except that the output voltage magnitude of the synchronous machine is controlled in magnitude (robust power grid) but uncontrolled in frequency. The active and reactive power control remains robust, stable and independent of each other, as shown in Fig. 5.

Active and reactive power control - Example 3

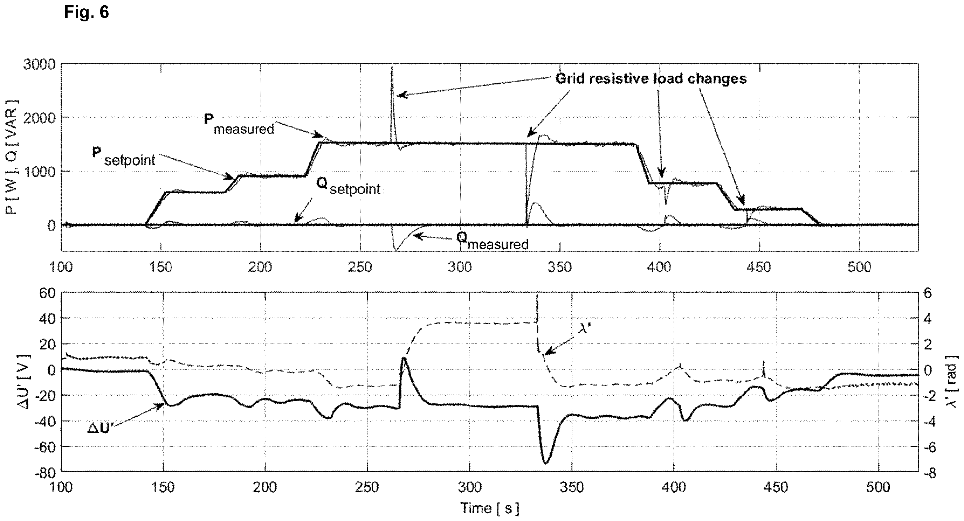

In this example, the system is coupled to the synchronous machine with variable resistive load. The active power control is decoupled from the reactive power control as they can be separately regulated by changing the respective setpoints. It will also be appreciated that the power control successfully adapts $\Delta U$' and $\lambda$' in order to minimize the active and reactive power deviations, even when the resistive load (grid impedance) abruptly changes, as shown in Fig. 6. With reference to Fig. 6, the resistive load is abruptly decreased at time t $\approx$ 265 s and abruptly increased at times t $\approx$ 335 s, t $\approx$ 402 s and t $\approx$ 440 s. A transitory regime appears after the abrupt changes in grid impedance, where the system adapts $\Delta U$' and $\lambda$' in order to restore the active and reactive powers to their setpoints values (see e.g. after the abrupt change at t $\approx$ 265 s) as shown in Fig. 6

While specific embodiments have been described herein in detail, those skilled in the art will appreciate that various modifications and alternatives to those details could be developed in light of the overall teachings of the disclosure. Accordingly, the particular arrangements disclosed are meant to be illustrative only and not limiting as to the scope of the invention, which is to be given the full breadth of the appended claims. In particular, it should be noted that even if the invention may be of particular interest in low-voltage grids, this does not mean that the invention shall be considered limited to such grids.

**Claims**

1. A method for operating a voltage source inverter (10), VSI, connected to a power grid (12) having a grid voltage ($V_{grid}$), the method comprising:

   controlling a magnitude of a VSI voltage and a phase between the VSI voltage ($V_{VSI}$) and the grid voltage ($V_{grid}$);
   determining active (P) and reactive (Q) powers exchanged between the VSI and the grid (S16);
   estimating (S26) one or more values indicative of the ratio of a grid conductance (G) and of a grid susceptance (B) based on said active and reactive powers (P, Q);
   **characterized in that** the method further comprises:

   determining (S18) an active power deviation ($e_P$) between said determined active power (P) and an active power setpoint as well as a reactive power deviation ($e_Q$) between said determined reactive power (Q) and a reactive power setpoint; mapping (S22) the active and reactive power deviations ($e_P$, $e_Q$) to a phase deviation ($e_\lambda$) and to a magnitude deviation ($e_{\Delta U}$), said mapping being dependent on the estimated one or more values indicative of the ratio of the grid conductance (G) and the grid susceptance (B); and correcting (S24) said magnitude of the VSI voltage and said phase between the VSI voltage ($V_{VSI}$) and the grid voltage ($V_{grid}$), based on said phase and magnitude deviations.

2. The method according to claim 1, wherein the correction of said magnitude of the VSI voltage and said phase between the VSI voltage ($V_{VSI}$) and the grid voltage ($V_{grid}$) comprises regulating the magnitude of the VSI voltage and the phase between the VSI voltage and the grid voltage ($V_{grid}$) so as to reduce the active and reactive power deviations ($e_P$, $e_Q$).

3. The method according to any one of claims 1 to 2, wherein the correction comprises injecting said phase and magnitude deviations ($e_\lambda$, $e_{\Delta U}$) into one of a proportional controller, integral controller, a derivative controller or a combination thereof, the output of the controller being used for regulating the magnitude of the VSI voltage and the phase between the VSI voltage ($V_{VSI}$) and the grid voltage ($V_{grid}$).

4. The method according to claim 3, wherein the controller is a proportional-integral controller or a proportional-integral-derivative controller.

5. The method according to any one of claims 1 to 4, comprising comparing the active and reactive power deviations to respective active and reactive power deviation thresholds, wherein the mapping and correcting steps are carried out as long as at least one of the active and reactive power deviations is greater than said respective thresholds and are suspended when both active and reactive power deviations are smaller than said respective thresholds.

6. The method according to any one of claims 1 to 5, wherein the estimation of the one or more values indicative of the ratio of the grid conductance (G) and of the grid susceptance (B) is also based on said phase and magnitude deviations ($e_\lambda$, $e_{\Delta U}$).

7. The method according to any one of claims 1 to 6, comprising an initial synchronisation of the VSI (10) with the grid (12).

8. The method according to any one of claims 1 to 7, wherein the grid (12) is a one-phase grid and the VSI (10) is a one-phase VSI.

9. The method according to any one of claims 1 to 7, wherein the grid (12) is a three-phase grid and the VSI (10) is a three-phase VSI.

10. On-the-fly power grid conductance (G) and susceptance estimation method using a VSI (10) connected to a power grid (12) having a grid voltage ($V_{grid}$), the conductance and susceptance estimation method carrying out the steps according to any one of claims 1 to 9.

11. A computer program product comprising a program for operating a VSI (10) connected to a power grid (12), the program comprising instructions, which, when executed by a computer controlling the VSI (10), causes the computer to carry out the steps of the method according to any one of claims 1 to 9.

12. A VSI (10) configured to carry out the steps of the method according to any one of claims 1 to 9.

13. The VSI (10) according to claim 10 comprising a switch for selectively carrying out the method for operating the VSI (10) according to any one of claims 1 to 9.

14. A VSI controller configured to carry out the steps of the method according to any one of claims 1 to 9.

**Patentansprüche**

1. Verfahren zum Betrieb eines Spannungsquellenwechselrichters (10) ("Voltage Source Inverter", VSI), verbunden mit einem Stromnetz (12), aufweisend eine Netzspannung ($V_{grid}$), wobei das Verfahren umfasst:

   Regeln eines Betrags einer VSI-Spannung und einer Phase zwischen der VSI-Spannung ($V_{VSI}$) und der Netzspannung ($V_{grid}$);
   Bestimmen von zwischen dem VSI und dem Netz (S16) ausgetauschten Wirkleistungen (P) und Blindleistungen (Q);
   Schätzen (S26) von ein oder mehreren Werten, die das Verhältnis eines Netz-Leitwerts (G) und eines Blindleitwerts (B) angeben, basierend auf den Wirkleistungen und Blindleistungen (P, Q);
   **dadurch gekennzeichnet, dass** das Verfahren ferner umfasst:

   Bestimmen (S18) einer Abweichung ($e_P$) der Wirkleistung zwischen der bestimmten Wirkleistung (P) und einem Sollwert der Wirkleistung sowie einer Abweichung ($e_Q$) der Blindleistung zwischen der bestimmten Blindleistung (Q) und einem Sollwert der Blindleistung;
   Abbilden (S22) der Abweichungen ($e_P$, $e_Q$) der Wirk- und Blindleistung auf eine Abweichung ($e_\lambda$) der Phase und auf eine Abweichung ($e_{\Delta U}$) des Betrags, wobei die Abbildung von den geschätzten ein oder mehreren Werten abhängig ist, die das Verhältnis des Netz-Leitwerts (G) und des Blindleitwerts (B) angeben, und Korrektur (S24) des Betrags der VSI-Spannung und der Phase zwischen der VSI-Spannung ($V_{VSI}$) und der Netzspannung ($V_{grid}$), basierend auf den Abweichungen von Phase und Betrag.

**2.** Verfahren nach Anspruch 1, wobei die Korrektur des Betrags der VSI-Spannung und der Phase zwischen der VSI-Spannung ($V_{VSI}$) und der Netzspannung ($V_{grid}$) das Regeln des Betrags der VSI-Spannung und der Phase zwischen der VSI-Spannung und der Netzspannung ($V_{grid}$) umfasst, um die Abweichungen ($e_P, e_Q$) der Wirk- und Blindleistung zu reduzieren.

**3.** Verfahren nach einem der Ansprüche 1 oder 2, wobei die Korrektur das Einspeisen der Abweichungen ($e_\lambda, e_{\Delta U}$) von Phase und Betrag in einen von einem Proportionalregler, einem Integralregler, einem Differenzialregler oder einer Kombination daraus umfasst, wobei die Ausgabe des Reglers zum Regeln des Betrags der VSI-Spannung und der Phase zwischen der VSI-Spannung ($V_{VSI}$) und der Netzspannung ($V_{grid}$) verwendet wird.

**4.** Verfahren nach Anspruch 3, wobei der Regler ein Proportional-IntegralRegler oder ein Proportional-Integral-Differenzial-Regler ist.

**5.** Verfahren nach einem der Ansprüche 1 bis 4, umfassend das Vergleichen der Abweichungen von Wirk- und Blindleistung mit dazugehörigen Abweichungsschwellenwerten der Wirk- und Blindleistung, wobei die Schritte des Abbildens und der Korrektur so lange durchgeführt werden, bis mindestens eine der Abweichungen von Wirk- und Blindleistung größer ist als die dazugehörigen Schwellenwerte, und eingestellt werden, wenn die Abweichungen sowohl der Wirk- als auch der Blindleistung geringer sind als die dazugehörigen Schwellenwerte.

**6.** Verfahren nach einem der Ansprüche 1 bis 5, wobei das Schätzen der ein oder mehreren Werte, die das Verhältnis des Netz-Leitwerts (G) und des Blindleitwerts (B) angeben, auch auf den Abweichungen ($e_\lambda, e_{\Delta U}$) von Phase und Betrag basiert.

**7.** Verfahren nach einem der Ansprüche 1 bis 6, umfassend eine anfängliche Synchronisation des VSI (10) mit dem Netz (12).

**8.** Verfahren nach einem der Ansprüche 1 bis 7, wobei das Netz (12) ein Ein-Phasen-Netz ist und der VSI (10) ein Ein-Phasen-VSI ist.

**9.** Verfahren nach einem der Ansprüche 1 bis 7, wobei das Netz (12) ein Drei-Phasen-Netz ist und der VSI (10) ein Drei-Phasen-VSI ist.

**10.** Spontanes Schätzverfahren für Leitwert (G) und Blindleitwert im Stromnetz unter Verwendung eines VSI (10), verbunden mit einem Stromnetz (12), aufweisend eine Netzspannung ($V_{grid}$), wobei das Schätzverfahren des Leitwerts und des Blindleitwerts die Schritte nach einem der Ansprüche 1 bis 9 durchführt.

**11.** Computerprogrammprodukt, umfassend ein Programm zum Betrieb eines VSI (10), verbunden mit einem Stromnetz (12), wobei das Programm Anweisungen umfasst, die bei Ausführung durch einen den VSI (10) steuernden Computer den Computer zum Durchführen der Schritte des Verfahrens nach einem der Ansprüche 1 bis 9 veranlassen.

**12.** VSI (10), ausgelegt zum Durchführen der Schritte des Verfahrens nach einem der Ansprüche 1 bis 9.

**13.** VSI (10) nach Anspruch 10, umfassend einen Schalter zum selektiven Durchführen des Verfahrens zum Betrieb des VSI (10) nach einem der Ansprüche 1 bis 9.

**14.** VSI-Regler, ausgelegt zum Durchführen der Schritte des Verfahrens nach einem der Ansprüche 1 bis 9.

**Revendications**

**1.** Procédé de fonctionnement d'un onduleur source de tension (10), VSI, connecté à un réseau électrique (12) ayant une tension de réseau ($V_{grid}$), le procédé comprenant les étapes suivantes :

contrôler l'amplitude d'une tension VSI et une phase entre la tension VSI ($V_{VSI}$) et la tension du réseau électrique ($V_{grid}$) ;
déterminer les puissances active (P) et réactive (Q) échangées entre le VSI et le réseau électrique (S16) ;
estimer (S26) une ou plusieurs valeurs indicatives du rapport d'une conductance de réseau électrique (G) et d'une susceptance de réseau électrique (B) sur la base desdites puissances active et réactive (P, Q) ;

**caractérisé en ce que** le procédé comprend en outre les étapes suivantes :

déterminer (S18) un écart de puissance active ($e_p$) entre ladite puissance active déterminée (P) et une consigne de puissance active ainsi qu'un écart de puissance réactive ($e_Q$) entre ladite puissance réactive déterminée (Q) et une consigne de puissance réactive ;

mettre en correspondance (S22) les écarts de puissances active et réactive ($e_p$, $e_Q$) avec un écart de phase ($e_\lambda$) et un écart d'amplitude ($e_{\Delta U}$), ladite mise en correspondance dépendant d'une ou de plusieurs valeurs estimées indicatives du rapport entre la conductance du réseau électrique (G) et la susceptance du réseau électrique (B) ; et

corriger (S24) ladite amplitude de la tension VSI et ladite phase entre la tension VSI ($V_{VSI}$) et la tension du réseau électrique ($V_{grid}$) sur la base desdits écarts de phase et d'amplitude.

2. Procédé selon la revendication 1, dans lequel la correction de ladite amplitude de la tension VSI et de ladite phase entre la tension VSI ($V_{VSI}$) et la tension du réseau électrique ($V_{grid}$) comprend la régulation de l'amplitude de la tension VSI et de la phase entre la tension VSI et la tension du réseau électrique ($V_{grid}$) de manière à réduire les écarts de puissance active et réactive ($e_p$, $e_Q$).

3. Procédé selon l'une quelconque des revendications 1 à 2, dans lequel la correction comprend l'injection desdits écarts de phase et d'amplitude ($e_\lambda$, $e_{\Delta U}$) dans l'un parmi un contrôleur proportionnel, un contrôleur intégratif, un contrôleur dérivatif, ou une combinaison de ceux-ci, la sortie du contrôleur étant utilisée pour réguler l'amplitude de la tension VSI et la phase entre la tension VSI ($V_{VSI}$) et la tension du réseau électrique ($V_{grid}$).

4. Procédé selon la revendication 3, dans lequel le contrôleur est un contrôleur proportionnel-intégratif ou un contrôleur proportionnel-intégratif-dérivatif.

5. Procédé selon l'une quelconque des revendications 1 à 4, comprenant de comparer les écarts de puissances active et réactive à des seuils d'écarts de puissances active et réactive respectifs, où les étapes de mise en correspondance et de correction sont exécutées tant qu'au moins un des écarts de puissances active et réactive est supérieur auxdits seuils respectifs, et sont suspendues lorsque les deux écarts de puissances active et réactive sont inférieurs auxdits seuils respectifs.

6. Procédé selon l'une quelconque des revendications 1 à 5, dans lequel l'estimation des une ou plusieurs valeurs indicatives du rapport de la conductance du réseau électrique (G) et de la susceptance du réseau électrique (B) est également basée sur lesdits écarts de phase et d'amplitude ($e_\lambda$, $e_{\Delta U}$).

7. Procédé selon l'une quelconque des revendications 1 à 6, comprenant une synchronisation initiale du VSI (10) avec le réseau électrique (12).

8. Procédé selon l'une quelconque des revendications 1 à 7, dans lequel le réseau électrique (12) est un réseau électrique monophasé et le VSI (10) est un VSI monophasé.

9. Procédé selon l'une quelconque des revendications 1 à 7, dans lequel le réseau électrique (12) est un réseau électrique triphasé et le VSI (10) est un VSI triphasé.

10. Procédé d'estimation à la volée de la conductance (G) et de la susceptance d'un réseau électrique utilisant un VSI (10) connecté à un réseau électrique (12) ayant une tension de réseau électrique ($V_{grid}$), le procédé d'estimation de la conductance et de la susceptance mettant en oeuvre les étapes selon l'une quelconque des revendications 1 à 9.

11. Produit programme informatique comprenant un programme pour faire fonctionner un VSI (10) connecté à un réseau électrique (12), le programme comprenant des instructions qui, lorsqu'elles sont exécutées par un ordinateur contrôlant le VSI (10), amènent l'ordinateur à exécuter les étapes du procédé selon l'une quelconque des revendications 1 à 9.

12. VSI (10) configuré pour exécuter les étapes du procédé selon l'une quelconque des revendications 1 à 9.

13. VSI (10) selon la revendication 10, comprenant un commutateur pour exécuter de manière sélective le procédé de fonctionnement du VSI (10) selon l'une quelconque des revendications 1 à 9.

14. Contrôleur de VSI configuré pour mettre en oeuvre les étapes du procédé selon l'une quelconque des revendications 1 à 9.

**Fig. 1**

**Fig. 2**

State (Sleep/Sync)

Sync? — S10

Y / N

Update $U$ and $\lambda$

Sync OK ? — S12

Y / N

Coupling — S14

$P$, $Q$ — S16

$e_P$, $e_Q$ — S18

Power OK ? — S20

Y / N

Control frame rotation — S22

$e_{\Delta U}$, $e_\lambda$

PI controllers — S24

$U$, $\Delta U'$, $\lambda'$

Impedance — S26

$R/|Z|$
$X/|Z|$

Stop ? — S28

Y / N

**Fig. 3**

Fig. 4

**Fig. 5**

EP 3 743 976 B1

Fig. 6

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2014060065 A
- WO 2012166933 A
- WO 2001081938 A
- EP 1643256 A
- DE 19522496
- WO 2014154298 A
- WO 2016202859 A

### Non-patent literature cited in the description

- **LISERRE, F. BLAAGJERG ; R. TEODORESCU.** Grid impedance detection via excitation of LCL-filter resonance. *IAS annual Meeting,* October 2005
- **LUCIAN ASIMINOAEI ; REMUS TEODORESCU ; FREDE BLAABJERG ; UFFE BORUP.** A Digital Controlled PV-Inverter with Grid Impedance Estimation for ENS Detection. *IEEE transactions on power electronics,* November 2005, vol. 20 (6
- **JONAS DE KOONING ; JAN VAN DE VYVER ; JEROEN D. M. DE KOONING ; TINE L. VANDOORN ; LIEVEN VANDEVELDE.** Grid voltage control with wind turbine inverters by using grid impedance estimation. *Renewable Power Generation Conference (RPG 2014),* September 2014
- **SURENA NESHVAD ; SYMEON CHATZINOTAS ; JÜRGEN SACHAU.** Online Determination of Grid Impedance Spectrum through Pseudo-Random Excitation of a Pulse Width Modulator. *International Conference on Renewable Energies and Power Quality (ICREPQ'14)*
- **XIAOQIANG GUO ; ZHIGANG LU ; XIAOFENG SUN ; HERONG GU ; WEIYANG WU.** New grid impedance estimation technique for grid-connected power converters. *Journal of Eng. Research,* September 2014, vol. 2 (3), 177-193
- **ABDELHADY GHANEM ; MOHAMED RASHED ; MARK SUMNER ; M. A. EL-SAYES ; I. I. I. MANSY.** Grid Impedance Estimation for Islanding Detection and Adaptive Control of Converters. *8th IET International Conference on Power Electronics, Machines and Drives,* 19 April 2016
- **KULKA ; ARKADIUSZ ; UNDELAND ; TORE.** Grid Inductance Estimation by Reactive Power Perturbation for Sensor-less Scheme Based on Virtual Flux. *Proceedings of the Nordic Workshop on Power and Industrial Electronics,* 2008